# EUROPÄISCHE PATENTANMELDUNG

(11) **EP 4 417 993 A1**
(43) Veröffentlichungstag der Anmeldung: **21.08.2024**
(21) Anmeldenummer: 23157044.1
(22) Anmeldetag: 16.02.2023
(51) Int. Cl.: G01R 33/38, G01R 33/3815, G01R 33/385

(54) **MAGNETRESONANZEINRICHTUNG UND VERFAHREN ZUM BETRIEB EINER KÜHLEINRICHTUNG IN EINER MAGNETRESONANZEINRICHTUNG**

(71) Anmelder: Siemens Healthineers AG, 91301 Forchheim (DE)
(72) Erfinder: Biber, Stephan, 91056 Erlangen (DE)
(74) Vertreter: Siemens Healthineers Patent Attorneys

(57) **Zusammenfassung**

Die Erfindung betrifft eine Magnetresonanzeinrichtung (1), aufweisend einen supraleitenden Hauptmagneten (2), einen Magnetkühler (3) für den Hauptmagneten (2) und eine Kühleinrichtung für den Magnetkühler (3) und weitere zu kühlende Komponenten (8) der Magnetresonanzeinrichtung (1), wobei die Kühleinrichtung einen Kühlkreislauf (6) mit einem mittels einer Pumpe (7) zur Zirkulation förderbaren Kühlmittel aufweist, wobei der Kühlkreislauf (6) einen ersten Teilkreislauf (14), an den der Magnetkühler (3) zur Kühlung angekoppelt ist, wenigstens einen zweiten Teilkreislauf (15, 15a, 15b) für die weiteren Komponenten (8) und einen gemeinsamen Anteil (16) aufweist, wobei wenigstens der zweite Teilkreislauf (15, 15a, 15b) eine Durchflusseinstelleinrichtung (19) zur Einstellung des Kühlmitteldurchflusses durch den Teilkreislauf (14, 15, 15a, 15b) aufweist und der Kühleinrichtung eine Steuereinrichtung (21) zugeordnet ist, die zur Ansteuerung der Pumpe (7) und/oder der Durchflusseinstelleinrichtung (19) in Abhängigkeit einer Betriebszustandsinformation der Magnetresonanzeinrichtung (1) ausgebildet ist.

## Beschreibung

Unabhängig vom grammatikalischen Geschlecht eines bestimmten Begriffes sind Personen mit männlicher, weiblicher oder anderer Geschlechteridentität mit umfasst.

Die Erfindung betrifft eine Magnetresonanzeinrichtung, aufweisend einen supraleitenden Hauptmagneten, einen Magnetkühler, insbesondere umfassend einen Kaltkopf, für den Hauptmagneten und eine Kühleinrichtung für den Magnetkühler und zu kühlende Komponenten der Magnetresonanzeinrichtung, wobei die Kühleinrichtung einem Kühlkreislauf mit einem mittels einer Pumpe zur Zirkulation förderbaren Kühlmittel aufweist. Daneben betrifft die Erfindung ein Verfahren zum Betrieb einer Kühleinrichtung in einer solchen Magnetresonanzeinrichtung.

Die Magnetresonanzbildgebung ist eine inzwischen gängige Modalität, insbesondere im medizinischen Bereich. Hierzu genutzte Magnetresonanzeinrichtungen weisen eine Vielzahl von Komponenten auf, die der Kühlung durch verschiedene Kühlsysteme bedürfen. Beispielsweise nutzen viele Magnetresonanzeinrichtungen supraleitende Hauptmagneten, die mittels eines Helium einsetzenden Magnetkühlers, der einen Heliumkompressor und einen Kaltkopf umfasst, gekühlt werden. Dieser Magnetkühler, insbesondere dessen Kompressor, erwärmt sich bei Betrieb ebenso und wird daher häufig durch eine Kühleinrichtung gekühlt, die auch weiteren Komponenten der Magnetresonanzeinrichtung zugeordnet ist. Solche weiteren, bei Verwendung der Magnetresonanzeinrichtung Wärme abgebenden Komponenten umfassen beispielsweise die Gradientenspulen einer Gradientenspulenanordnung, den zugeordneten Gradientenverstärker, einen Hochfrequenzverstärker, insbesondere Luft nutzende Elektronikkühler sowie auch bedarfsweise eingesetzte Komponenten wie Lasten zum Herunterfahren des Hauptmagneten (Run-Down Load - RDL). Als Kühlmittel nutzen derartige Kühleinrichtungen üblicherweise Wasser, welches bereits gekühlt bereitgestellt werden kann und/oder durch eine Kühleinheit der Kühleinrichtung, beispielsweise einen Wärmetauscher, gekühlt werden kann. Das Kühlmittel wird mittels einer Pumpe in einem Kühlkreislauf der Kühleinrichtung zirkuliert.

Dabei sind im Stand der Technik zwei grundsätzliche Konfigurationen bekannt. In sogenannten passiven Kühleinrichtungen wälzt die Pumpe das Wasser zur Kühlung der Komponenten und des Magnetkühlers um, wobei Wärme über einen Wärmetauscher an Primärwasser des Kunden abgegeben wird. Im sogenannten aktiven Kühleinrichtungen wird das Wasser durch eine Wärme an die Außenluft abgebende Kühleinheit, insbesondere einen sogenannten "Chiller", geführt.

Bekannt ist es im Übrigen auch, zur Stabilisierung der Kühlmitteltemperatur eine Mischbatterie für das Kühlmittel zu verwenden, welche warmes und kaltes Kühlmittel mischt, um eine stabile bzw. gewollte Kühlmitteltemperatur zu erreichen. Dies gilt insbesondere im Hinblick auf eine Kühlung mittels der Außenluft.

Kühleinrichtungen benötigen zu ihrem Betrieb elektrische Energie. Dabei existiert bei Magnetresonanzeinrichtungen die Besonderheit, dass aufgrund des dauerhaften Betriebs des Hauptmagneten auch bei anderweitig nicht genutzter Magnetresonanzeinrichtung ein kontinuierlicher, andauernder Kühlvorgang erforderlich ist. Weist eine Magnetresonanzeinrichtung beispielhaft drei Betriebsmodi auf, nämlich einen ausgeschalteten Betriebszustand, einen Untersuchungsbetriebszustand und einen Stand-By-Betriebszustand, kommt den zu kühlenden Komponenten, die einen permanenten Leistungsbedarf haben, also in allen diesen Betriebsmodi, eine besondere Bedeutung zu, da die Reduktion des Leistungsverbrauchs sich bei diesen Komponenten am stärksten auf die Reduktion des Energieverbrauchs der Kühleinrichtung auswirkt.

Bei solchen Kühleinrichtungen für Magnetresonanzeinrichtungen ist die verfügbare Kühlleistung, die dem Magnetkühler und den weiteren Komponenten zugeführt werden kann, von verschiedenen Parametern abhängig. Bei der aktiven Kühleinrichtung sind dies insbesondere die Eigenschaften der Kühleinheit, insbesondere des Chillers, und der Außenluft, insbesondere deren Temperatur. Bei der passiven Kühleinrichtung sind diese abhängig von der Durchflussmenge und der Wassertemperatur des Primärwassers am Verbauort. Im Gegensatz dazu ist die benötigte Kühlleistung durch den dynamischen Betrieb und die Speichereigenschaften der Komponenten der Magnetresonanzeinrichtung, umfassend neben den bereits genannten Komponenten auch Wasser in Schläuchen und dergleichen, schwer vorhersehbar. In jedem Fall liegt eine hohe Dynamik vor, da die genaue benötigte Kühlleistung stark vom Betriebszustand abhängt. Zwischen dem bereits erwähnten ausgeschalteten Betriebszustand (4 - 8 kW Grundlast) und einer Untersuchung mit einer einfachen Magnetresonanzsequenz liegen nur wenige kW, zwischen einer einfachen Magnetresonanzsequenz und einer energieintensiven Magnetresonanzsequenz können mehrere 10 kW liegen.

Um hinsichtlich des Betriebs der Pumpe, die das Kühlmittel im Kühlkreislauf zirkuliert, elektrische Energie einzusparen, wurde bereits vorgeschlagen, drei Pumpenzustände zu nutzen, die den drei bereits erwähnten Betriebsmodi zugeordnet sind. Dabei wird die Pumpleistung, insbesondere die Drehzahl der Pumpe, in dem ausgeschalteten Betriebszustand und dem Stand-By-Betriebszustand deutlich niedriger gewählt als während einer Untersuchung. Dabei ist beachten, dass heutige Pumpen, insbesondere Wasserumwälzpumpen, in Magnetresonanzeinrichtungen ca. 1 - 2,5 kW Leistung benötigen. Dies entspricht einer elektrischen Gesamtenergie von 8 - 20 MWh pro Jahr. Bereits eine Einsparung im Bereich von 10 - 20 % wäre mithin äußerst wünschenswert.

US 10 823 791 B2 beschreibt ein Verfahren und eine Magnetresonanzeinrichtung zur Überwachung der Funktion einer Kühleinrichtung der Magnetresonanzeinrichtung. Hierbei werden zumindest einem Teil der Komponenten der Magnetresonanzeinrichtung, die durch das Kühlsystem gekühlt werden, Temperatursensoren zugeordnet, wobei aus einer Starttemperatur eine Vergleichsvariable erzeugt wird und die späteren Temperaturen mit der Vergleichsvariablen verglichen werden, um das Auslösen von Aktionen zu steuern.

Der Erfindung liegt die Aufgabe zu Grunde, eine insbesondere technisch einfach umsetzbare Möglichkeit zur Reduzierung des Energieverbrauchs bei Kühleinrichtungen für Magnetresonanzeinrichtungen anzugeben.

Zur Lösung dieser Aufgabe ist bei einer Magnetresonanzeinrichtung der eingangs genannten Art erfindungsgemäß vorgesehen, dass der Kühlkreislauf einen ersten Teilkreislauf, an den der Magnetkühler zur Kühlung angekoppelt ist, wenigstens einen zweiten Teilkreislauf für die weiteren Komponenten und einen gemeinsamen Anteil, in dem insbesondere die Pumpe vorgesehen ist, aufweist, wobei wenigstens der zweite Teilkreislauf eine Durchflusseinstelleinrichtung zur Einstellung des Kühlmitteldurchflusses durch den Teilkreislauf aufweist und der Kühleinrichtung eine Steuereinrichtung zugeordnet ist, die zur Ansteuerung der Pumpe und/oder der Durchflusseinstelleinrichtung in Abhängigkeit einer Betriebszustandsinformation der Magnetresonanzeinrichtung ausgebildet ist.

Es wird eine Lösung vorgeschlagen, die eine Energieeinsparung für die speziellen Anforderungen einer Magnetresonanzeinrichtung zur Magnetresonanzbildgebung ermöglicht. Diese speziellen Anforderungen sind die Notwendigkeit der dauerhaften Kühlung des Hauptmagneten durch den Hauptkühler, insbesondere den Kaltkopf des Heliumkompressors, die Anforderung der Kühlung der für die Magnetresonanzbildgebung nötigen Komponenten sowie die dynamischen Unterschiede in der Wärmeabgabe.

Dabei wird konkret vorgeschlagen, im Kühlkreislauf der Kühleinrichtung wenigstens zwei Teilkreisläufe vorzusehen, die vollständig getrennt sind, mithin keine gemeinsamen Abschnitte enthalten. Der erste Teilkreislauf beinhaltet wenigstens die Komponenten, die permanent zur Kühlung benötigt werden, insbesondere also den Magnetkühler. Der wenigstens eine zweite Teilkreislauf beinhaltet die Komponenten, die nur im Untersuchungsbetrieb, also bei der Magnetresonanzbildgebung, benötigt werden und die auch während der Untersuchung eher dynamische Wärmelast an die Kühleinrichtung abgeben. Anders gesagt umfassen die weiteren Komponenten des zweiten Kühlkreislaufs nur im Untersuchungsbetrieb der Magnetresonanzeinrichtung verwendete Komponenten der Magnetresonanzeinrichtung und an den ersten Kühlkreislauf sind alle zur Kühlung des Hauptmagneten notwendigen Einrichtungen angekoppelt, die vorliegend mit dem Begriff des Magnetkühlers zusammengefasst sind. Der Magnetkühler umfasst insbesondere wenigstens den Kaltkopf und den Heliumkompressor.

In bevorzugten Ausführungsbeispielen wird der Kühlmittelfluss, wobei als Kühlmittel bevorzugt Wasser verwendet wird, durch beide parallel geschalteten Teilkreisläufe von einer ansteuerbaren Pumpe, die im gemeinsamen Anteil vorgesehen ist, getrieben. Hierbei kann die Ansteuerung der Pumpe beispielsweise über einen Umrichter erfolgen. Zumindest für den wenigstens einen zweiten Teilkreislauf ist es möglich, dem Kühlmittelfluss einen Flusswiderstand entgegenzusetzen, mithin den Durchfluss ebenso ansteuerbar zu regeln, wozu die Durchflusseinstelleinrichtung vorgesehen ist. Wird nun beispielsweise der zweite Teilkreislauf abgeriegelt, sodass dort kein Durchfluss mehr stattfindet, ist es möglich, die Pumpenleistung zu reduzieren und dennoch den nötigen, insbesondere zeitlich konstanten Durchfluss durch den ersten Kühlkreislauf zu erzeugen. Bereits durch diese einfache Maßnahme ist eine signifikante Einsparung von Energie möglich, nachdem beispielsweise die Steuereinrichtung ausgebildet sein kann, immer dann, wenn die weiteren Komponenten nicht benötigt werden und somit keine Wärmeleistung, die abgeführt werden muss, erzeugen, den wenigstens einen zweiten Teilkreislauf zu sperren und die Pumpenleistung zu reduzieren. Auf diese Weise können beispielsweise mehrere 100 W Leistung der Pumpe und damit ca. 0,1 - 1 MWh Energie pro Jahr eingespart werden.

Möglich ist es im Rahmen der vorliegenden Erfindung auch, mehr als eine Pumpe zu verwenden, insbesondere in den Teilkreisläufen je eine Pumpe vorzusehen. Auch hier kann entsprechend Pumpleistung eingespart werden, da beispielsweise in abgeriegelten zweiten Teilkreisläufen auf Pumpleistung verzichtet werden kann. Bevorzugt und daher im Folgenden hauptsächlich diskutiert ist jedoch die Lösung mit, insbesondere genau, einer Pumpe im gemeinsamen Anteil.

Allgemein gesprochen kann gesagt werden, dass die Steuereinrichtung zur Ansteuerung der Pumpe und/oder der Durchflusseinstelleinrichtung zur Erfüllung eines Optimierungsziels neben einem Ansteuerungsziel, welches ausreichende Kühlung beschreibt, eingerichtet ist, wobei das Optimierungsziel eine Reduzierung des Energieverbrauchs, insbesondere der Pumpe, ist. Die vorliegende Erfindung ermöglicht also die Reduktion des Energiebedarfs für die Kühlmittelpumpe, insbesondere Wasser-Umwälzpumpe, der Kühleinrichtung der Magnetresonanzeinrichtung durch eine Aufteilung des Kühlkreislaufs und eine Steuerung des Durchflusses der Teilkreisläufe.

Beispielsweise können die weiteren Komponenten eine Gradientenspulenanordnung und/oder einen Gradientenverstärker (GPA) und/oder einen Hochfrequenzverstärker (RFPA) und/oder eine Abschaltlast für den Hauptmagneten und/oder einen Elektronickühler umfassen. Dies sind selbstverständlich nur Beispiele; alle, insbesondere bei einer Magnetresonanzuntersuchung, Wärmeleistung, die abgeführt werden muss, erzeugenden Komponenten der Magnetresonanzeinrichtung können zweckmäßigerweise an den wenigstens einen zweiten Teilkreislauf zur Kühlung angeschlossen sein. Eine Abschaltlast für den Hauptmagneten (Run-Down Load - RDL) kann beispielsweise ein Aluminiumblock oder dergleichen sein, der beim gewollten, gezielten Herunterfahren des Hauptmagneten genutzt werden soll. Ein Elektronikkühler kann beispielsweise einen zur Luftkühlung von Elektronickomponenten der Magnetresonanzeinrichtung eingesetzten Lüfter, insbesondere einen Ventilator, umfassen.

Der gemeinsame Anteil des Kühlkreislaufs kann wenigstens eine Kühleinheit, insbesondere einen Wärmetauscher zur Außenluft, zur Kühlung des Kühlmittels aufweisen. Derartige Kühleinheiten werden häufig als Wärmetauscher und/oder Wärmepumpe zur Außenluft, sogenannte "Chiller", umgesetzt, um die Außenluft zu nutzen. Denkbar ist es aber auch im Rahmen der vorliegenden Erfindung, eine Kühlung des Kühlmittels, insbesondere mittels eines Wärmetauschers, durch Primärwasser am Verbauort bereitzustellen.

Zweckmäßigerweise kann die Durchflusseinstelleinrichtung wenigstens ein elektronisch und/oder thermostatisch regelbares Ventil aufweisen. Allgemein gesagt kann also der Durchfluss durch den wenigstens einen zweiten Kühlkreislauf durch Anpassung des Flusswiderstandes geregelt werden. Die Flusswiderstandseinstellung kann über wenigstens ein einstellbares Ventil erreicht werden. Dabei kann das einstellbare Ventil elektronisch und/oder thermostatisch geregelt werden, wobei im alleinigen letzterem Fall eine weitgehend statische Regelkurve gegeben ist, weswegen die elektronische Ansteuerbarkeit, die einen komplexeren Regelbetrieb ermöglicht, bevorzugt ist. Zweckmäßigerweise können für jeden zweiten Teilkreislauf zwei Ventile verwendet werden, wobei ein erstes Ventil am Einfluss in den jeweiligen Teilkreislauf und ein zweites Ventil am Ausfluss aus dem jeweiligen Teilkreislauf angeordnet ist. Soll der Durchfluss reduziert werden, beispielsweise in einem ausgeschalteten Betriebszustand der Magnetresonanzeinrichtung, kann das wenigstens eine Ventil, insbesondere beide Ventile, ganz oder fast ganz abgeregelt werden.

In einer vorteilhaften Ausgestaltung kann vorgesehen, dass die Betriebszustandsinformation einen aktuellen Betriebsmodus der Magnetresonanzeinrichtung beschreibt, wobei die Steuereinrichtung zur Auswahl einer dem aktuellen Betriebsmodus zugeordneten Einstellung wenigstens für die Durchflusseinstelleinrichtung ausgebildet ist. Das bedeutet, wenn festgestellt wird, dass ein bestimmter Betriebsmodus aktuell vorliegt, nutzt die Steuereinrichtung die diesem Betriebsmodus zugeordnete, insbesondere in einem Speichermittel der Speichereinrichtung abgelegte Einstellung, um die Durchflusseinstelleinrichtung entsprechend anzusteuern. Damit ist eine besonders einfache Nutzbarkeit der Teilkreisläufe und der Durchflusseinstelleinrichtung realisierbar, indem vom Betriebsmodus abhängig bestimmte feste Einstellungen herangezogen werden, wobei in einer solchen Ausgestaltung zweckmäßigerweise den Betriebsmodi auch eine Einstellung für die wenigstens eine Pumpe zugeordnet sein kann.

Denkbar ist es aber auch, dass der Betriebsmodus und die Einstellung zumindest der Durchflusseinstelleinrichtung für diesen lediglich eine Grundlage für einen weitergehenden Regelbetrieb darstellt, der sich dann beispielsweise auf die Pumpe und/oder weitere Kühleinrichtungskomponenten beziehen kann. Grundsätzlich ist es aber auch denkbar, die Einstellung für den Betriebsmodus als einen Startpunkt oder die Vorgabe eines bestimmten Regelbetriebs zu sehen, auf den folgend auch noch eine weitere Ansteuerung der Durchflusseinstelleinrichtung im Regelbetrieb folgen kann.

In einer konkreten Ausgestaltung kann vorgesehen sein, dass wenigstens einer der Betriebsmodi aus der Gruppe umfassend einen ausgeschalteten Zustand, einen Stand-By-Zustand und einen Untersuchungszustand gewählt ist, wobei
- dem ausgeschalteten Zustand eine weniger als 10 % des Maximaldurchflusses, insbesondere keinerlei Durchfluss, erlaubende Einstellung der Durchflusseinstelleinrichtung zugeordnet ist,
- dem Untersuchungszustand eine mehr als 90 % des Maximaldurchflusses, insbesondere den Maximaldurchfluss, erlaubende Einstellung der Durchflusseinstelleinrichtung zugeordnet ist, und
- dem Standby-Zustand eine zwischen dem erlaubten Durchfluss in dem ausgeschalteten Zustand und dem erlaubten Durchfluss in dem Untersuchungszustand liegenden Durchfluss erlaubende Einstellung der Durchflusseinstelleinrichtung zugeordnet ist.

Insbesondere wird in diesem Zusammenhang aufgrund des geringeren Durchflusses durch den wenigstens einen zweiten Teilkreislauf eine gegenüber dem Untersuchungszustand reduzierte Pumpenleistung zugeordnet, die auch gegenüber der Pumpenleistung reduziert ist, die erforderlich wäre, wenn sowohl der erste als auch der zweite Teilkreislauf vollständig durchflossen würden. Dabei sei angemerkt, dass es grundsätzlich denkbar ist, im Standby-Zustand denselben Durchfluss wie im ausgeschalteten Zustand zu verwenden, ein zumindest leicht erhöhter Durchfluss jedoch bevorzugt ist.

Wie bereits erwähnt, kann, allgemein gesprochen, jedem Betriebsmodus auch eine Einstellung der Pumpe zugeordnet sein. Bereits auf diese Weise ist selbst bei einer einfachen Ausgestaltung ohne einen tiefergehenden Regelbetrieb hinsichtlich der Durchflusseinstelleinrichtung und/oder der Pumpe eine deutliche Reduzierung des Energiebedarfs möglich.

Vorteilhafte Ausführungsbeispiele ergeben sich jedoch auch, wenn die Steuereinrichtung innerhalb wenigstens eines Betriebsmodus zur Ansteuerung der Pumpe im Rahmen eines Regelbetriebs ausgebildet ist. Beispielsweise ist bei einer Ausgestaltung denkbar, die für jeden Betriebsmodus einen bestimmten Durchfluss durch den wenigstens einen zweiten Teilkreislauf mittels einer bestimmten Einstellung der Durchflusseinstelleinrichtung vorgibt, innerhalb des Betriebsmodus jedoch ein Regelbetrieb hinsichtlich wenigstens der Pumpe nutzt, welcher eine weitere Reduzierung des Energieverbrauchs der Pumpe ermöglicht.

Auch allgemein jedoch kann, in Kombination mit Betriebsmodi zugeordneten Einstellungen oder aber ohne Nutzung derselben, vorgesehen sein, dass die Steuereinrichtung zu einem kontinuierlichen Regelbetrieb der Kühleinrichtung, insbesondere hinsichtlich wenigstens einer Soll-Temperatur, ausgebildet ist. Dabei werden in dem Regelbetrieb zweckmäßigerweise wenigstens die Pumpe und die Durchflusseinstelleinrichtung zur Umsetzung der Regelung angesteuert, gegebenenfalls jedoch auch weitere Kühleinrichtungskomponenten. Beispielsweise ist es im Untersuchungsbetrieb, also bei der Magnetresonanzbildgebung, denkbar, nicht, wie im Stand der Technik üblich, den Maximaldurchfluss durch den zweiten Teilkreislauf umzuwälzen, sondern die Flussmenge auf den tatsächlichen Bedarf zu reduzieren und die Pumpe entsprechend herunterzuregeln, um Energie zu sparen.

Konkret kann vorgesehen sein, dass die zum Regelbetrieb genutzte Betriebszustandsinformation umfasst:
- wenigstens eine mittels eines Temperatursensors der Magnetresonanzeinrichtung gemessene Temperatur in dem Kühlkreislauf und/oder in oder an dem Magnetkühler und/oder in oder an wenigstens einer weiteren Komponente, und/oder
- eine Außentemperatur und/oder eine Außenluftfeuchtigkeit einer insbesondere zur Kühlung des Kühlmittels verwendeten Außenluft, und/oder wenigstens eine prädiktive und/oder aus vergangenen Nutzungsvorgängen ermittelte Wärmeleistungsinformation pro Komponente und/oder Gruppe von Komponenten.

Als Eingangsgrößen in die Regelung, insbesondere zur Ansteuerung der Durchflusseinstelleinrichtung, können die Temperaturmesswerte verschiedener Temperatursensoren dienen. Insbesondere bei einer bevorzugten elektronischen Regelung können hierbei viele Temperaturen genutzt werden, beispielsweise Temperatursensoren des wenigstens einen zweiten Teilkreislaufs, Temperatursensoren der Komponenten selbst und/oder Kühlmitteltemperaturen im gemeinsamen Anteil, insbesondere des durch wenigstens eine Kühleinheit gekühlten Kühlmittels. Dabei ist die Nutzung von Temperatursensoren der Komponenten selbst dahingehend zweckmäßig, dass bei sehr niedrigem Durchfluss eine Komponente gegebenenfalls warm werden kann, bevor dies im Kühlmittel, also in Temperaturmesswerten des zweiten Teilkreislaufs, sichtbar ist. Wird die Temperatur an oder in Komponenten selbst verwendet, ist ein solcher Temperaturanstieg frühzeitig feststellbar und es kann beispielsweise der Durchfluss erhöht werden und/oder eine andere Regelmaßnahme ergriffen werden. Insbesondere können die Temperaturen an oder in Komponenten und Kühlmitteltemperaturen, insbesondere im zweiten Kühlkreislauf, gemeinsam in den zum Regelbetrieb in der Steuereinrichtung genutzten Regelalgorithmus eingehen. Dies ermöglicht es, die Zeitkonstanten der einzelnen Komponenten mit in die Regelschleife einzubeziehen. Insbesondere kann vorgesehen sein, dass der Temperaturanstieg an einzelnen Temperatursensoren im Regelbetrieb genutzt wird, insbesondere um Zeitkonstanten zu ermitteln beziehungsweise abzuschätzen.

Gerade im Untersuchungsbetrieb, also wenn sich dynamisch ändernde Wärmeleistungen insbesondere an den weiteren Komponenten, die an den zweiten Teilkreislauf angeschlossen sind, auftreten können, kann es zweckmäßig sein, die benötigte Kühlleistung, insbesondere vorausschauend, bereits - zumindest abgeschätzt - zu kennen, bevor die Wärmeentwicklung, beispielsweise mittels Temperatursensoren, messbar wird. Hierzu können weitere Parameter der Magnetresonanzeinrichtung in einen zur Umsetzung des Regelbetriebs genutzten Regelalgorithmus eingehen. Derartige Anteile der Betriebszustandsinformation können genutzt werden, um prädiktiv und/oder unter Nutzung vergangener Nutzungsvorgänge eine Wärmeleistungsinformation, insbesondere pro Komponente und/oder pro Gruppe von Komponenten, zu ermitteln. Beispielsweise kann vorgesehen sein, dass die Steuereinrichtung zur Ermittlung der Wärmeleistungsinformation aus Eingangsdaten unter Verwendung eines in der Steuereinrichtung abgelegten Leistungsmodells und/oder einer in der Steuereinrichtung abgelegten trainierten Ermittlungsfunktion der künstlichen Intelligenz ausgebildet ist.

Die Eingangsdaten können dabei gewählt sein aus der Gruppe umfassend:
- wenigstens eine zukünftig zu nutzende Magnetresonanzsequenz beschreibende Sequenzdaten,
- einen Untersuchungstyp beschreibende Untersuchungsdaten, insbesondere beschreibend eine klinische Fragestellung und/oder eine zu untersuchende Körperregion, und
- einen zu untersuchenden Patienten beschreibende Patientendaten, insbesondere ein Alter und/oder ein Geschlecht und/oder ein Gewicht.

Dabei sei zunächst darauf hingewiesen, dass im Stand der Technik bereits Leistungsmodelle zur Vorhersage von benötigten elektrischen Leistungen und/oder entstehenden Wärmeleistungen vorgeschlagen wurden, die auch im Rahmen der vorliegenden Erfindung entsprechend eingesetzt werden können. Besonders zweckmäßig ist es in diesem Zusammenhang allgemein, wenn eine Abfolge mehrerer zukünftig zu nutzender Magnetresonanzsequenzen bekannt ist, entsprechende Vorausberechnungen nicht nur auf die nächstfolgende Magnetresonanz zu erstrecken, sondern auf mehrere, insbesondere alle, Magnetresonanzsequenzen der Abfolge, wobei dann die entsprechend am Ende einer Magnetresonanzsequenz entstehenden vorausberechneten Zustände der Magnetresonanzeinrichtung als Startzustand für die folgende Magnetresonanzsequenz genutzt werden können. Denkbar ist es auch, wenn Magnetresonanzsequenzen einen Vorbereitungsschritt in der Magnetresonanzeinrichtung nutzen, für eine gestartete Magnetresonanzsequenz in dem Vorbereitungsschritt ermittelte Eingangsdaten als Betriebszustandsinformation abzurufen und die Leistungsanforderungen für die Laufzeit der Magnetresonanzsequenz, beispielsweise 1 bis 5 Minuten, abzuleiten. Wie bereits erwähnt, kann jedoch auch für noch in einer Warteschlange befindliche Magnetresonanzsequenzen eine Vorausberechnung genutzt werden, um die zu erwartenden Wärmeleistungen und somit die voraussichtlich benötigten Kühlleistungen abzuschätzen. Dabei können auf Magnetresonanzsequenzen bezogene Eingangsdaten, also Betriebszustandsinformationen, einfach gehalten werden, beispielsweise als Sequenztyp und/oder Sequenzname, aber auch dezidierter sein, beispielsweise Pulsabfolgen beschreiben. Allgemein kann gesprochen kann zur Abschätzung der Wärmeleistung und somit der benötigten Kühlleistung für eine momentan laufende oder zukünftige Magnetresonanzsequenz auch Information zur Körperregion, die untersucht werden soll, und/oder zum Patienten herangezogen werden, um die Vorausberechnung/Abschätzung zu verbessern. Insbesondere ist es in diesem Zusammenhang auch denkbar, eine in der Steuereinrichtung abgelegte trainierte Ermittlungsfunktion der künstlichen Intelligenz zu nutzen, um auch komplexere Zusammenhänge abbilden zu können.

Im Allgemeinen bildet eine trainierte Funktion kognitive Funktionen ab, die Menschen mit anderen menschlichen Gehirnen assoziieren. Durch Training basierend auf Trainingsdaten (Maschinenlernen) ist die trainierte Funktion in der Lage, sich an neue Umstände anzupassen und Muster zu detektieren und zu extrapolieren.

Allgemein gesagt können Parameter einer trainierten Funktion durch Training angepasst werden. Insbesondere können überwachtes Lernen, halbüberwachtes Lernen, nicht überwachtes Lernen, Reinforcement Learning und/oder aktives Lernen verwendet werden. Darüber hinaus kann auch Repräsentationslernen (auch "Feature Learning" bekannt) eingesetzt werden. Die Parameter der trainierten Funktion können insbesondere iterativ durch mehrere Trainingsschritte angepasst werden.

Eine trainierte Funktion kann beispielsweise ein neuronales Netz, eine Support Vector Machine (SVM), einen Entscheidungsbaum und/oder ein Bayes-Netzwerk umfassen und/oder die trainierte Funktion kann auf k-Means-Clustering, Q-Learning, genetischen Algorithmen und/oder Zuordnungsregeln basieren. Insbesondere kann ein neuronales Netzwerk ein tiefes neuronales Netzwerk, ein Convolutional Neural Network (CNN) oder ein tiefes CNN sein. Darüber hinaus kann das neuronale Netzwerk ein Adversarial Network, ein tiefes Adversarial Network und/oder ein Generative Adversarial Network (GAN) sein.

In einer zweckmäßigen Weiterbildung kann der Magnetkühler mittels einer Steuereinheit regelbar sein, wobei die Betriebszustandsinformation eine von der Steuereinheit bereitgestellte Regelinformation umfasst. Diese Regelinformation kann, insbesondere im ausgeschalteten Zustand und/oder im Standby-Zustand, zur Anpassung der Pumpenleistung der Pumpe ausgewertet werden. Auf diese Weise können verschiedene Ansätze zum Einsparen von elektrischer Energie bei Magnetresonanzeinrichtungen zusammengeführt werden, denn es wurde bereits vorgeschlagen, zur Reduzierung des Energiebedarfs auch den Betrieb des Magnetkühlers, insbesondere des Heliumkompressors, an den tatsächlichen Kühlleistungsbedarf des Hauptmagneten anzupassen. Beispielsweise kann in diesem Zusammenhang vorgesehen sein, dass der Magnetkühler mit einer bestimmten Taktung ein- und ausgeschaltet wird. Ein weiterer Ansatz ist die Regelung des Magnetkühlers durch Steuerung der Drehzahl, beispielsweise bei einem Umrichter. Bei beiden Vorgehensweisen würde auch die benötigte Kühlleistung der Kühleinrichtung durch das Kühlmittel entsprechend der Ansteuerung des Magnetkühlers schwanken. Wird nun mittels der Steuereinrichtung auf diese Schwankungen durch eine geeignete Anpassung der Pumpenleistung reagiert, kann diese dann, wenn weniger Kühlleistung für den Magnetkühler benötigt wird, reduziert werden, sodass weitere Energie eingespart werden kann. Hierzu wird die Regelinformation von der Steuereinheit des Magnetkühlers genutzt. Dabei sei angemerkt, dass diese Ausgestaltung - Anpassung der Pumpenleistung an die tatsächlich benötigte Kühlleistung am Magnetkühler - auch unabhängig von der Bereitstellung von Teilkreisläufen für unterschiedliche Komponenten der Magnetresonanzeinrichtung vorteilhaft ist und entsprechend realisiert werden kann.

Wie bereits erwähnt, wurde es im Stand der Technik bereits vorgeschlagen, eine ansteuerbare Mischbatterie zur Mischung von kaltem und warmem Kühlmittel einzusetzen. Dies kann auch im Rahmen der vorliegenden Erfindung geschehen, wobei dann zweckmäßig die ansteuerbare Mischbatterie entsprechend in die Steuerung durch die Steuereinrichtung eingebunden werden kann. So kann konkret vorgesehen sein, dass der gemeinsame Anteil eine ansteuerbare Mischbatterie zum Mischen von Kühlmittel im Vorlauf zu den Teilkreisen aus Kühlmittel im Vorlauf und im Rücklauf von einer Kühleinheit, insbesondere dem Wärmetauscher, für das Kühlmittel aufweist, wobei die Steuereinrichtung, insbesondere beim Regelbetrieb, auch zur Ansteuerung der Mischbatterie in Abhängigkeit von der Betriebszustandsinformation ausgebildet ist.

In einer zweckmäßigen Weiterbildung der vorliegenden Erfindung kann ferner vorgesehen sein, dass die Steuereinrichtung zum Anlernen und Verwenden eines Selbstlernalgorithmus zum Ermitteln zu verwendender Einstellungen für die Pumpe und/oder die Durchflusseinstelleinrichtung ausgebildet ist. Dabei sind eine Vielzahl von konkreten Ausgestaltungen denkbar, um während des Betriebs der Kühleinrichtung lernend Schlussfolgerungen zu ziehen, wobei der Selbstlernalgorithmus insbesondere auch eine trainierte Funktion der künstlichen Intelligenz umfassen kann. Hierbei ist es beispielsweise denkbar, aus der Vergangenheit ein zu erwartendes Verhalten der Nutzer der Magnetresonanzeinrichtung für die Zukunft abzuschätzen, sodass auch diesbezüglich eine Abschätzung der erforderlichen Kühlleistung erfolgen kann. Mit besonderem Vorteil jedoch kann die Steuereinrichtung mittels des Selbstlernalgorithmus, insbesondere als selbstlernendes System der künstlichen Intelligenz, die Energieeinsparung selbstlernend immer weiter optimieren, indem die Rückregelung der Pumpe zusammen mit dem Steuern des Durchflusses im wenigstens einem zweiten Kühlkreislauf immer weiter ausgetestet wird, bis Toleranzgrenzen überschritten werden. Anders gesagt kann vorgesehen sein, dass die Steuereinrichtung beim Anlernen zum zeitlichen Verändern wenigstens einer Einstellung, insbesondere außerhalb des Untersuchungsbetriebs, der Pumpe und/oder der Durchflusseinstelleinrichtung ausgebildet ist, bis eine Toleranztemperatur in dem Kühlkreislauf und/oder an oder in dem Magnetkühler und/oder an oder in wenigstens einer der weiteren Komponenten überschritten ist. Die wenigstens eine Toleranztemperatur ist dabei zweckmäßigerweise so gewählt, dass weiterhin, auch bei leichtem Überschreiten, ein sicherer Betrieb der Magnetresonanzeinrichtung möglich ist. Erst eine zweite, höhere Toleranztemperatur führt zu Fehlermeldungen und/oder Abschaltungen. Auf diese Weise lernt die Steuereinrichtung über die Zeit selbst, wie eine optimale Einsparung von Energie, insbesondere für die Pumpe, erfolgen kann.

Eine zweckmäßige Weiterbildung der vorliegenden Erfindung sieht vor, dass mehrere zweite Teilkreise mit jeweiligen Durchflusseinstelleinrichtungen zur Kühlung von Untergruppen der weiteren Komponenten vorgesehen sind. Es ist also möglich, mehrere unabhängig regelbare zweite Teilkreisläufe vorzusehen, um eine noch feinere Einstellbarkeit und insbesondere "Wegschaltbarkeit" von zu kühlenden Komponenten in zweiten Teilkreisläufen zu ermöglichen. Dann ist es beispielsweise denkbar, wenn nur ein Teil der weiteren Komponenten benötigt wird, nur für diese weiter Kühlmittelzirkulation bereitzustellen und andere zweite Teilkreisläufe abzuregeln, sodass dann insbesondere auch eine Reduzierung der Pumpenleistung erfolgen kann. Konkret kann hierbei vorgesehen sein, dass die Aufteilung der weiteren Komponenten in Untergruppen wenigstens teilweise auf einer örtlichen Nähe von Komponenten und/oder einer zeitlich korrelierenden Nutzung von Komponenten basiert. Dabei ist es bevorzugt, wenn weitere Komponenten mit ähnlichem zeitlichen Kühlleistungsbedarf im selben Teilkreislauf an die Kühlung angebunden sind. Dann ist damit zu rechnen, dass die weiteren Komponenten der entsprechenden Untergruppe auch in ähnlichem Zeitintervallen Kühlung benötigen und in ähnlichen Zeitintervallen von der Kühlung temporär abgetrennt werden können. Auch eine zumindest teilweise räumliche Zuordnung kann erfolgen, um das Verlegen von Leitungen für die Teilkreisläufe zu verbessern. Beispielsweise kann eine erste Untergruppe Gradientenspulen und eine Abschaltlast für den Hauptmagneten umfassen und eine zweite Untergruppe den Gradientenverstärker, den Hochfrequenzverstärker und einen Elektronikkühler.

Neben der Magnetresonanzeinrichtung betrifft die vorliegende Erfindung auch ein Verfahren zum Betrieb einer Kühleinrichtung in einer erfindungsgemäßen Magnetresonanzeinrichtung, welches sich dadurch auszeichnet, dass die Steuereinrichtung die Pumpe und/oder die Durchflusseinstelleinrichtung in Abhängigkeit einer Betriebszustandsinformation der Magnetresonanzeinrichtung ansteuert. Sämtliche Ausführungen bezüglich der erfindungsgemäßen Magnetresonanzeinrichtung lassen sich analog auf das erfindungsgemäße Verfahren übertragen, mit welchem mithin ebenso die bereits genannten Vorteile erhalten werden können.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine funktionale Prinzipskizze relevanter Komponenten einer erfindungsgemäßen Magnetresonanzeinrichtung gemäß einer ersten Ausführungsform, und
- Fig. 2: eine funktionale Prinzipskizze relevanter Komponenten einer erfindungsgemäßen Magnetresonanzeinrichtung gemäß einer zweiten Ausführungsform.

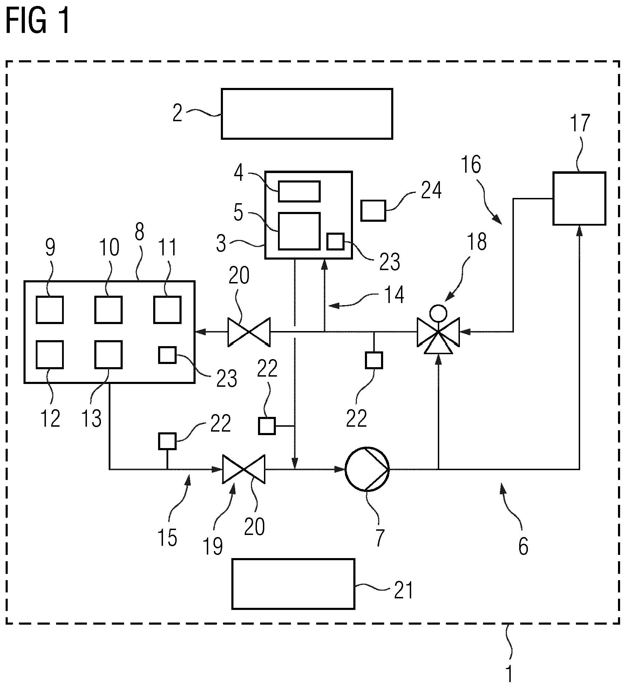

Fig. 1 zeigt eine funktionale Prinzipskizze eines ersten Ausführungsbeispiels einer erfindungsgemäßen Magnetresonanzeinrichtung 1. Die Magnetresonanzeinrichtung 1 umfasst einen supraleitenden Hauptmagneten 2, dem ein Magnetkühler 3 mit einem Kaltkopf 4 und einem Heliumkompressor 5 zur Kühlung zugeordnet ist. Der Magnetkühler 3, insbesondere der Heliumkompressor 5, bedarf selbst der Kühlung, weshalb die Magnetresonanzeinrichtung 1 eine Kühleinrichtung mit einem Kühlkreislauf 6 aufweist, in dem, durch eine Pumpe 7 getrieben, Kühlmittel, hier Wasser, zirkuliert. Die Kühleinrichtung ist auch zur Kühlung weiterer Komponenten 8 der Magnetresonanzeinrichtung 1 ausgebildet, von denen vorliegend beispielhaft eine Gradientenspulenanordnung 9, ein Gradientenverstärker 10, ein Hochfrequenzverstärker 11, eine Abschaltlast 12 für den Hauptmagneten 2 und ein Elektronikkühler 13 gezeigt sind. Während der supraleitende Hauptmagnet dauerhaft, also auch in einem ausgeschalteten Zustand der Magnetresonanzeinrichtung 1, gekühlt werden muss, werden die weiteren Komponenten 8 nicht immer genutzt, sondern, insbesondere was die Gradientenspulenanordnung 9, den Gradientenverstärker 10, die Hochfrequenzverstärker 11 und den Elektronikkühler 13 angeht, nur bei einer Untersuchung mit der Magnetresonanzeinrichtung 1, also einer Magnetresonanzbildgebung, genutzt. Selbstverständlich sind auch weitere Komponenten 8 denkbar, die der Kühlung bedürfen.

Der Kühlkreislauf 6 der Kühleinrichtung ist vorliegend in einen ersten Teilkreislauf 14, in dem der Magnetkühler 3 gekühlt wird, einen zweiten Teilkreislauf 15, in dem die weiteren Komponenten 8 gekühlt werden, und einen gemeinsamen Anteil 16 aufgeteilt. Der gemeinsame Anteil 16 umfasst neben der Pumpe 7 eine Kühleinheit 17, beispielsweise einen Chiller, der einen Wärmetauscher und/oder eine Wärmepumpe zur Außenluft umfassen kann. In dem gemeinsamen Anteil 16 ist ferner eine Mischbatterie 18 vorgesehen, die zur Mischung von kaltem Wasser der Kühleinheit 17 mit warmem Wasser aus den Rückflüssen der Teilkreisläufe 14, 15 angesteuert werden kann.

Der zweite Teilkreislauf 15 weist eine Durchflusseinstelleinrichtung 19 auf, die vorliegend zwei elektronisch steuerbare Ventile 20 aufweist, eines im Vorlauf, eines im Rücklauf. Mittels den Ventilen 20 kann der Durchfluss durch den zweiten Teilkreislauf 15 eingestellt werden.

Der Betrieb der Kühleinrichtung wird mittels einer Steuereinrichtung 21 gesteuert, die vorliegend die Durchflusseinstelleinrichtung 19, also die Ventile 20, die Pumpe 7 und die Mischbatterie 18 ansteuern kann. Dies erfolgt auf Basis einer Betriebszustandsinformation. Die Steuerung erfolgt dabei derart, dass zum einen als Ansteuerungsziel eine hinreichende Kühlung des Magnetkühlers 3 unter weiteren Komponenten 8 erreicht wird, zum anderen als Optimierungsziel jedoch der Energiebedarf, insbesondere für die Pumpe 7, reduziert wird.

Insbesondere was die Durchflusseinstelleinrichtung 19 angeht, sind hierbei sowohl einfachere als auch kompliziertere Konzepte denkbar, wobei es beispielsweise möglich ist, dass die Einstellungen für die Durchflusseinstelleinrichtung 19 und die Pumpe 7 bereits aus einem vorliegenden Betriebsmodus folgen und der Regelbetrieb hinsichtlich der Temperatur zumindest hauptsächlich durch Ansteuerung der Mischbatterie 18 erfolgt. Dabei sind als Betriebsmodi beispielsweise ein ausgeschalteter Zustand, ein Standby-Zustand und ein Untersuchungszustand denkbar, wobei im ausgeschalteten Zustand, in dem nur der Magnetkühler 3 aufgrund des kontinuierlichen Kühlbedarfs für den Hauptmagneten 2 der Kühlung bedarf, die Ventile 20 auf sehr geringen, insbesondere sogar gar keinen, Durchfluss eingestellt werden können. Entsprechend kann die Pumpleistung der Pumpe 7 reduziert werden, da das Kühlmittel nur noch durch den ersten Teilkreislauf 14 gefördert werden muss, nicht mehr jedoch durch den zweiten Teilkreislauf 15. Eine ähnliche Einstellung kann im Standby-Zustand genutzt werden, wobei dann bereits eine leichte Öffnung der Ventile 20 vorgesehen werden kann. Im Untersuchungszustand jedoch sind die Ventile 20 offen, um so auch eine Kühlung der weiteren Komponenten 8, die sich bei der Magnetresonanzbildgebung erwärmen, im zweiten Teilkreislauf 15 zu ermöglichen.

Besonders vorteilhaft ist es jedoch, wenn die Pumpe 7 und auch die Durchflusseinstelleinrichtung 19 in den Regelbetrieb mit einbezogen werden, was zusätzlich oder alternativ zu den Einstellungen für die verschiedenen Betriebsmodi erfolgen kann.

Dabei ist es zweckmäßig, wenn die Betriebszustandsinformation, die der Steuerung in der Steuereinrichtung 21 zu Grunde liegt, möglichst umfangreich ist, sodass ein Bild entsteht, dass die benötigten Kühlleistungen deutlich beschreibt und somit Einsparpotential für die Steuereinrichtung 21 offenlegt.

Als erste Quelle von Betriebszustandsinformation umfasst die Magnetresonanzeinrichtung 1 Temperatursensoren 22 zur Messung der Kühlmitteltemperatur im Kühlkreislauf 6, wobei lediglich beispielhafte mögliche Positionen gezeigt sind und selbstverständlich auch weitere Temperatursensoren 22 vorgesehen werden können, sowie Temperatursensoren 23 zur Messung der Temperatur an und/oder in den weiteren Komponenten 8 sowie gegebenenfalls dem Magnetkühler 3. Beispielsweise besteht im Untersuchungsbetrieb Energieeinsparungspotential, indem die Kühlung nicht länger, wie im Stand der Technik üblich, den maximalen Kühlmitteldurchfluss durch den zweiten Kühlkreislauf 15 umwälzt, sondern die Flussmenge auf den tatsächlichen Bedarf reduziert wird und parallel die Pumpe 7 entsprechend heruntergeregelt wird, mithin mit geringerer Pumpleistung betrieben wird. Allgemein können als Eingangsgrößen für einen solchen Regelbetrieb, aber auch für andere Arten des Regelbetriebs, Temperaturmesswerte der Temperatursensoren 22, 23 herangezogen werden. Hierbei sind die Temperatursensoren 23 an oder in den weiteren Komponenten 8 besonders nützlich, da bei sehr niedrigem Durchfluss von Kühlmittel im zweiten Teilkreislauf 15 eine weitere Komponente 8 eventuell erwärmen kann, bevor dies im Kühlmittel über den entsprechenden Sensor 22 im Rücklauf des zweiten Teilkreislaufs 15 messbar ist. Durch die Nutzung der Temperaturmesswerte der Temperatursensoren 23 der weiteren Komponenten 8 im Regelalgorithmus kann ein Temperaturanstieg früh sensiert werden, um bei Temperaturanstieg durch Ansteuerung der Durchflusseinstelleinrichtung 19 den Durchfluss zu erhöhen. Zweckmäßigerweise gehen die Temperaturmesswerte der weiteren Komponenten 8 und die Kühlmitteltemperatur im zweiten Teilkreislauf 15 gemeinsam in den Regelalgorithmus ein, um Zeitkonstanten und Differenztemperaturen, insbesondere Temperaturanstiege an einzelnen Temperatursensoren 22, 23, korrekt einschätzen und berücksichtigen zu können.

Zusätzlich oder alternativ kann die Betriebszustandsinformation auch direkt oder indirekt zu erwartende, benötigte Kühlleistungen beziehungsweise entsprechend entstehende Wärmeleistungen in den weiteren Komponenten 8 beschreiben. Konkret kann vorgesehen sein, dass die Steuereinrichtung 21 eine Wärmeleistungsinformation für die weiteren Komponenten 8 aus in der Betriebszustandsinformation enthaltenen Eingangsdaten ermittelt, wozu ein in der Steuereinrichtung 21 abgelegtes Leistungsmodell und/oder eine in der Steuereinrichtung 21 abgelegte trainierte Ermittlungsfunktion der künstlichen Intelligenz verwendet werden können. Die Eingangsdaten können dabei eine aktuell ausgespielte und/oder zukünftig zu nutzende Magnetresonanzsequenz beschreibende Sequenzdaten, einen Untersuchungstyp beschreibende Untersuchungsdaten und/oder einen zu untersuchenden Patienten beschreibende Patientendaten umfassen. Für eine bereits gestartete Magnetresonanzsequenz können beispielsweise aus einem Vorbereitungsschritt ("Sequenz-Prepare") Leistungsanforderungen für die Laufzeit der Magnetresonanzsequenz abgeleitet werden und hieraus Wärmeleistungsinformationen für die weiteren Komponenten 8 ermittelt werden. Eine Vorausberechnung kann auch für vorausgeplante Magnetresonanzsequenzen erfolgen. Je nach in der Steuereinrichtung 21 selbst vorliegenden Informationen und der Natur des Leistungsmodells beziehungsweise der Ermittlungsfunktion können Sequenzdaten, allgemein gesagt, einen Sequenztyp und/oder einen Sequenznamen und/oder die Pulsfolge der Magnetresonanzsequenz beschreibende Pulsdaten umfassen. Zur Abschätzung der entstehenden Wärmeleistung und damit der benötigten Kühlleistung über aktuell laufende und/oder zukünftige Sequenzen kann die Steuereinrichtung 21 auch Untersuchungsdaten, beispielsweise eine zu untersuchende Körperregion und/oder eine klinische Fragestellung, sowie Patientendaten, beispielsweise ein Alter und/oder ein Geschlecht und/oder ein Gewicht des Patienten, heranziehen.

Allgemein nützlich als Betriebszustandsdaten sind im Übrigen ferner auch, wenn eine Kühlung des Kühlmittels über Außenluft erfolgt, die Außenlufttemperatur und/oder die Außenluftfeuchtigkeit, da dann beispielsweise auch eine Abschätzung der zur Verfügung stehenden Kühlleistung erfolgen kann.

Im vorliegenden Ausführungsbeispiel knüpft die Steuerung der Steuereinrichtung 21 auch an Energieeinsparmaßnahmen hinsichtlich des Magnetkühlers 3, die durch eine dortige Steuereinheit 24 bewirkt werden, an. Diese Energiebedarfseinsparung hinsichtlich des Magnetkühlers 3 kann dabei zwei unterschiedlichen Ansätzen folgen. Zum einen ist es denkbar, den Magnetkühler 3 intermittierend ein- und auszuschalten, beispielsweise in einem Takt, dessen Zeitabstände größer als zehn Minuten sind. Zusätzlich oder alternativ kann der Magnetkühler 3, insbesondere der Kompressor 5, auch geregelt werden, insbesondere durch Steuerung der Drehzahl über einen Umrichter. In beiden Fällen schwankt entsprechend auch die benötigte Kühlleistung für den Magnetkühler 3 durch die Kühleinrichtung. Da die Steuereinheit 24 eine entsprechende Regelinformation an die Steuereinrichtung 21 als Betriebszustandsinformation bereitstellt, kann die Pumpleistung entsprechend dem tatsächlich benötigten Kühlungsbedarf des Magnetkühlers 3 angepasst werden, um weitere Energieeinsparung zu erreichen.

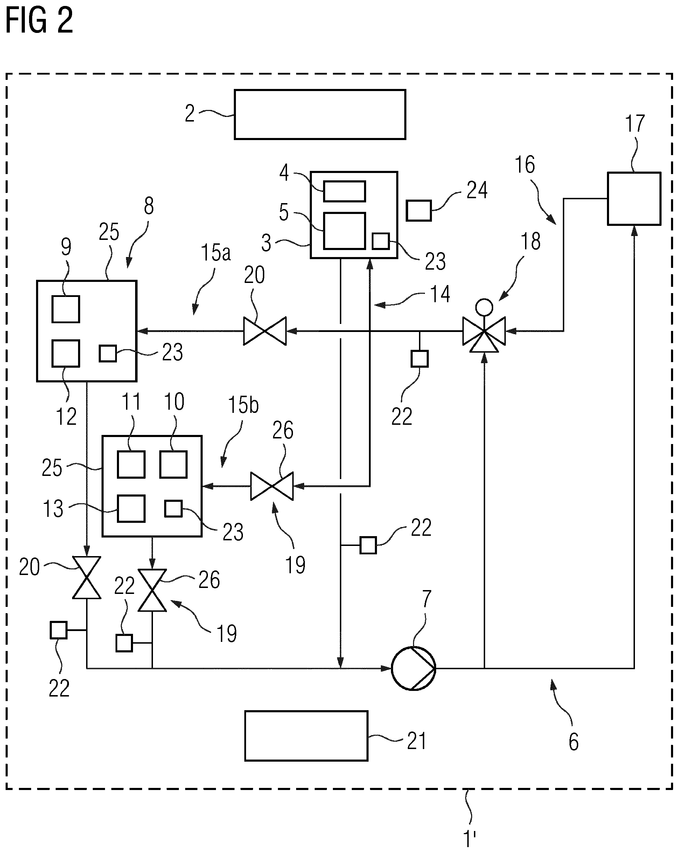

Fig. 2 zeigt eine gegenüber Fig. 1 modifizierte zweite Ausführungsform einer erfindungsgemäßen Magnetresonanzeinrichtung 1'. Im Unterschied zu Fig. 1 sind die weiteren Komponenten 8 vorliegend in zwei Untergruppen 25 aufgeteilt, die jeweils an einen von zwei zweiten Teilkreisläufen 15a, 15b angeschlossen sind. Beide zweite Teilkreisläufe 15a, 15b sind über ihre eigene Durchflusseinstelleinrichtung 19 im Kühlmitteldurchfluss abregelbar, der zweite Teilkreislauf 15a über die Ventile 20, und der zweite Teilkreislauf 15b über die Ventile 26.

Die konkreten Komponenten 8 in den Untergruppen 25 wurden dabei aufgrund zeitlich korrelierender erzeugter Wärmeleistung und/oder einer räumlichen Nähe zusammengestellt. Das bedeutet insbesondere, dass wenigstens ein Teil der weiteren Komponenten 8 jeder Untergruppe 25 ähnlichen zeitlichen Kühlleistungsbedarf aufweist. Vorliegend sind beispielhaft als Mitglieder der Untergruppe 25 des ersten zweiten Teilkreislaufs 15a die Gradientenspulenanordnung 9 und die Abschaltlast 12 gezeigt, als Komponenten der Untergruppe 25 des zweiten zweiten Teilkreislaufs 15b der Gradientenverstärker 10, der Hochfrequenzverstärker 11 und der Elektronikkühler 13.

Aufgrund des Kühlleistungsbedarfs in den Teilkreisläufen 15a, 15b zu unterschiedlichen Zeiträumen können durch eine getrennte Durchflusssteuerung ebenso Energieeinsparungen, insbesondere hinsichtlich der Pumpenleistung, erreicht werden.

Zu den sonstigen Komponenten und Steuer- sowie Regelmöglichkeiten der Steuereinrichtung 21 sei auf die Ausführungen zum ersten Ausführungsbeispiel verwiesen.

Für beide Ausführungsbeispiele kann die Steuereinrichtung 21 auch einen Selbstlernalgorithmus, der eine trainierte Funktion der künstlichen Intelligenz umfassen kann, aufweisen, um weitere Optimierungsmöglichkeiten beim Energiebedarf, insbesondere seitens der Pumpe 7, selbst zu erlernen. Insbesondere kann das so gebildete selbstlernende System die Energieeinsparung selbstlernend immer weiter optimieren, indem die Rückregelung der Pumpe 7 zusammen mit dem Abtrennen wenigstens eines der zweiten Teilkreisläufe 15, 15a, 15b immer weiter "ausgetestet" wird, bis kritische Toleranztemperaturen, beispielsweise an den weiteren Komponenten 8 (Temperatursensoren 23) oder am Kühlmittel (Temperatursensoren 22) eine Toleranztemperatur überschreiten, die noch immer ein sicheren Betrieb erlaubt und niedriger gewählt ist, als eine höhere Toleranzgrenze, die zu Fehlermeldungen oder Abschaltungen führt. Auf diese Weise lotet die Steuereinrichtung 21 mittels des Selbstlernalgorithmus letztlich selbst die möglichen Grenzen aus. Der Selbstlernalgorithmus kann, allgemein gesprochen, auf sämtliche nötigen Eingangsinformationen, die er benötigt, zurückgreifen, beispielsweise auch die bereits erwähnten Sequenzdaten, Untersuchungsdaten und/oder Patientendaten.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Magnetresonanzeinrichtung (1), aufweisend einen supraleitenden Hauptmagneten (2), einen Magnetkühler (3) für den Hauptmagneten (2) und eine Kühleinrichtung für den Magnetkühler (3) und weitere zu kühlende Komponenten (8) der Magnetresonanzeinrichtung (1), wobei die Kühleinrichtung einen Kühlkreislauf (6) mit einem mittels einer Pumpe (7) zur Zirkulation förderbaren Kühlmittel aufweist,
**dadurch gekennzeichnet, dass** der Kühlkreislauf (6) einen ersten Teilkreislauf (14), an den der Magnetkühler (3) zur Kühlung angekoppelt ist, wenigstens einen zweiten Teilkreislauf (15, 15a, 15b) für die weiteren Komponenten (8) und einen gemeinsamen Anteil (16) aufweist, wobei wenigstens der zweite Teilkreislauf (15, 15a, 15b) eine Durchflusseinstelleinrichtung (19) zur Einstellung des Kühlmitteldurchflusses durch den Teilkreislauf (14, 15, 15a, 15b) aufweist und der Kühleinrichtung eine Steuereinrichtung (21) zugeordnet ist, die zur Ansteuerung der Pumpe (7) und/oder der Durchflusseinstelleinrichtung (19) in Abhängigkeit einer Betriebszustandsinformation der Magnetresonanzeinrichtung (1) ausgebildet ist.

2. Magnetresonanzeinrichtung (1) nach Anspruch 1, **dadurch gekennzeichnet, dass** die Durchflusseinstelleinrichtung (19) wenigstens ein elektronisch und/oder thermostatisch regelbares Ventil (20, 26) aufweist.

3. Magnetresonanzeinrichtung (1) nach einem der vorangehenden Ansprüche, **dadurch gekennzeichnet, dass** die Betriebszustandsinformation einen aktuellen Betriebsmodus der Magnetresonanzeinrichtung (1) beschreibt, wobei die Steuereinrichtung (21) zur Auswahl einer dem aktuellen Betriebsmodus zugeordneten Einstellung wenigstens für die Durchflusseinstelleinrichtung (19) ausgebildet ist.

4. Magnetresonanzeinrichtung (1) nach Anspruch 3, **dadurch gekennzeichnet, dass** wenigstens einer der Betriebsmodi aus der Gruppe umfassend einen ausgeschalteten Zustand, einen Standby-Zustand und einen Untersuchungszustand gewählt ist, wobei
- dem ausgeschalteten Zustand eine weniger als 10% des Maximaldurchflusses, insbesondere keinerlei Durchfluss, erlaubende Einstellung der Durchflusseinstelleinrichtung (19) des zweiten Teilkreislaufs (15, 15a, 15b) zugeordnet ist,
- dem Untersuchungszustand eine mehr als 90% des Maximaldurchflusses, insbesondere den Maximaldurchfluss, erlaubende Einstellung der Durchflusseinstelleinrichtung (19) des zweiten Teilkreislaufs (15, 15a, 15b) zugeordnet ist, und
- dem Standby-Zustand eine einen zwischen dem erlaubten Durchfluss in dem ausgeschalteten Zustand und dem erlaubten Durchfluss in dem Untersuchungszustand liegenden Durchfluss erlaubende Einstellung der Durchflusseinstelleinrichtung (19) des zweiten Teilkreislaufs (15, 15a, 15b) zugeordnet ist.

5. Magnetresonanzeinrichtung (1) nach Anspruch 3 oder 4, **dadurch gekennzeichnet, dass** jedem Betriebsmodus auch eine Einstellung der Pumpe (7) zugeordnet ist.

6. Magnetresonanzeinrichtung (1) nach einem der Ansprüche 3 bis 5, **dadurch gekennzeichnet, dass** die Steuereinrichtung (21) innerhalb wenigstens eines Betriebsmodus zur Ansteuerung der Pumpe (7) im Rahmen eines Regelbetriebs ausgebildet ist.

7. Magnetresonanzeinrichtung (1) nach einem der vorangehenden Ansprüche, **dadurch gekennzeichnet, dass** die Steuereinrichtung (21) zu einem kontinuierlichen Regelbetrieb der Kühleinrichtung, insbesondere hinsichtlich wenigstens einer Soll-Temperatur, ausgebildet ist.

8. Magnetresonanzeinrichtung (1) nach Anspruch 7, **dadurch gekennzeichnet, dass** die zum Regelbetrieb genutzte Betriebszustandsinformation umfasst:
- wenigstens eine mittels eines Temperatursensors (22, 23) der Magnetresonanzeinrichtung (1) gemessene Temperatur in dem Kühlkreislauf (6) und/oder in oder an dem Magnetkühler (3) und/oder wenigstens einer weiteren Komponente (8), und/oder
- eine Außentemperatur und/oder eine Außenluftfeuchtigkeit einer insbesondere zur Kühlung des Kühlmittels verwendeten Außenluft, und/oder
- wenigstens eine prädiktive und/oder aus vergangenen Nutzungsvorgängen ermittelte Wärmeleistungsinformation pro Komponente (8) und/oder Gruppe von Komponenten (8).

9. Magnetresonanzeinrichtung (1) nach Anspruch 8, **dadurch gekennzeichnet, dass** die Steuereinrichtung (21) zur Ermittlung der Wärmeleistungsinformation aus Eingangsdaten unter Verwendung eines in der Steuereinrichtung (21) abgelegten Leistungsmodells und/oder einer in der Steuereinrichtung (21) abgelegten trainierten Ermittlungsfunktion der künstlichen Intelligenz ausgebildet ist.

10. Magnetresonanzeinrichtung (1) nach Anspruch 9, **dadurch gekennzeichnet, dass** die Eingangsdaten gewählt sind aus der Gruppe umfassend:
- wenigstens eine zukünftig zu nutzende Magnetresonanzsequenz beschreibende Sequenzdaten,
- einen Untersuchungstyp beschreibende Untersuchungsdaten, und
- einen zu untersuchenden Patienten beschreibende Patientendaten.

11. Magnetresonanzeinrichtung (1) nach einem der Ansprüche 7 bis 10, **dadurch gekennzeichnet, dass** der Magnetkühler (3) mittels einer Steuereinheit (24) regelbar ist, wobei die Betriebszustandsinformation eine von der Steuereinheit (24) bereitgestellte Regelinformation umfasst.

12. Magnetresonanzeinrichtung (1) nach einem der vorangehenden Ansprüche, **dadurch gekennzeichnet, dass** der gemeinsame Anteil (16) eine ansteuerbare Mischbatterie (18) zum Mischen von Kühlmittel im Vorlauf zu den Teilkreisen (14, 15, 15a, 15b) aus Kühlmittel im Vorlauf und im Rücklauf von einer Kühleinheit (17), insbesondere einem Wärmetauscher, für das Kühlmittel aufweist, wobei die Steuereinrichtung (21), insbesondere beim Regelbetrieb, auch zur Ansteuerung der Mischbatterie (18) in Abhängigkeit von der Betriebszustandsinformation ausgebildet ist.

13. Magnetresonanzeinrichtung (1) nach einem der vorangehenden Ansprüche, **dadurch gekennzeichnet, dass** die Steuereinrichtung (21) zum Anlernen und Verwenden eines Selbstlernalgorithmus zum Ermitteln zu verwendender Einstellungen für die Pumpe (7) und/oder die Durchflusseinstelleinrichtung (19) ausgebildet ist.

14. Magnetresonanzeinrichtung (1) nach einem der vorangehenden Ansprüche, **dadurch gekennzeichnet, dass** mehrere zweite Teilkreise (15a, 15b) mit jeweiligen Durchflusseinstelleinrichtungen (19) zur Kühlung von Untergruppen (25) der weiteren Komponenten (8) vorgesehen sind.

15. Magnetresonanzeinrichtung nach einem der vorangehenden Ansprüche, **dadurch gekennzeichnet, dass** die Pumpe (7) in dem gemeinsamen Anteil (16) angeordnet ist.

16. Verfahren zum Betrieb einer Kühleinrichtung in einer Magnetresonanzeinrichtung (1), die nach einem der vorangehenden Ansprüche ausgebildet ist, **dadurch gekennzeichnet, dass** die Steuereinrichtung (21) die Pumpe (7) und/oder die Durchflusseinstelleinrichtung (19) in Abhängigkeit einer Betriebszustandsinformation der Magnetresonanzeinrichtung (1) ansteuert.
